## Europäisches Patentamt
## European Patent Office
## Office européen des brevets

(11) Publication number: **0 052 048**
**B1**

(12) **EUROPEAN PATENT SPECIFICATION**

(45) Date of publication of patent specification: **02.12.87**

(51) Int. Cl.⁴: **H 03 M 1/10**

(21) Application number: **81401721.6**

(22) Date of filing: **28.10.81**

(54) Method and apparatus for A/D and D/A converter testing.

<table>
<tr><td>

(30) Priority: **07.11.80 US 204979**

(43) Date of publication of application:
**19.05.82 Bulletin 82/20**

(45) Publication of the grant of the patent:
**02.12.87 Bulletin 87/49**

(84) Designated Contracting States:
**BE DE FR GB IT NL SE**

(56) References cited:
**IEEE INTERNATIONAL AUTOMATIC TESTING
CONFERENCE, Autotestcon, Conference
Record, CH1416-7/78, November 25-30, 1978,
San Diego, C.A. (US) L.F.PAU."Fast testing and
trimming of A/D and D/A converters in
automatic test systems ", pages 268-247
IEEE TRANSACTIONS ON INSTRUMENTATION
AND MEASUREMENT, vol.IM-22, no.3,
September 1973, New York (US)H.U.KOLLER:
"New criterion for testing analog-to-digital
converters for statistical evaluation", pages
214-217**

</td><td>

(73) Proprietor: **FAIRCHILD CAMERA &
INSTRUMENT CORPORATION
464 Ellis Street
Mountain View California 94042 (US)**

(72) Inventor: **Sloane, Edwin A.
1040 Covington Road
Los Altos California 94022 (US)**

(74) Representative: **Chareyron, Lucien et al
Schlumberger Limited Service Brevets c/o Giers
12, place des Etats Unis B.P. 121
F-92124 Montrouge Cédex (FR)**

(56) References cited:
**IEEE TRANSACTIONS ON INSTRUMENTATION
AND MEASUREMENT, vol.IM-28, no.4,
December 1979, New York (US) T.M.SOUDERS
et al.: " An automated test set for high
resolution analog-to-digital and digital-to-
analog converters", pages 239-244
IBM TECHNICAL DISCLOSURE BULLETIN,
vol.19, no.11, April 1977, New York (US)
R.J.PRILIK: "Testing method for digital-to-
analog converter and an analog-to-digital
converter", pages 4255-4256**

</td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**0 052 048**

(58) References cited:
**ELEKTRONIK, vol.28, no.20, October 1979,
München (DE) M.ZIMMER: "Testen schneller
Analog/Digital-Umsetzer mit Tischrechnern",
pages 61-66**

**RADIOFERNSEHEN ELEKTRONIK, vol.27, no.7,
July 1978B.SCHILDWACH et al.: "Abgleich und
Prüfung von Analog-Digital- und Digital-
analog-Umsetzern", pages 425-427**

**Description**

Background of the invention
1. Field of invention
This invention relates to automatic test systems and particularly to methods and apparatus for dynamically testing analog-to-digital (A/D) converters and digital-to-analog (D/A) converters.

Converters between the digital and analog domains are employed to interface digital electronic circuitry and devices producing analog signals. Accuracy of conversion gain and repeatability in the process of conversion are matters of concern which are important to evaluate, and if possible, optimize a calibration procedure.

2. Description of the prior art
Current state of the art testing techniques for converters are generally limited to testing a few states, such as major transitions for analog-to-digital converters and such as the simple binary weights and full-scale amplitude for digital-to-analog converters. Substantially all tests are static in nature and are incapable of providing a complete statistical evaluation of the converter.

Dynamic testing techniques have been suggested for limited purposes. An example is a method proposed by L. F. Pau and presented in a paper entitled "Fast Testing and Trimming of A/D and D/A Converters in Automatic Test Systems" at the 1978 IEEE Autotest Conference. Pau has suggested one method of dynamic testing employing excitation signals characterized by Walsh functions. The evaluation method pressupposes the use of an ideal reference device, the output response of which is employed with the output response of a device under test to generate an error signal from which optimization decisions are made. A device built according to the techniques suggested by Pau is therefore limited by the accuracy of the referenced device.

Another example is the technique disclosed in Radiofernsehen Elektronik, Vol. 27, No. 7, July 1978, on pages 425 to 427. In this document a technique for testing an analog-to-digital converter or a digital-to-analog converter is disclosed comprising applying an excitation signal to the converter to be tested to produce an output response signal and examining the output response signal in order to determine deviation of the output signal so produced from the output of an ideal reference device. This technique is also dependent upon the availability of an ideal reference device.

Summary of the invention
According to the invention, a method and apparatus is provided for dynamically testing the overall performance characteristics of digital-to-analog converters and analog-to-digital converters as claimed. The method comprises dynamically exercising a converter with analog or digital signal patterns. The method according to Claim 1, is characterized in that said known signal consists of a set of orthogonal digital functions over a defined interval and has its amplitude substantially uniformly distributed among allowable states to approximate a maximum entropy sequence signal; and further characterized by the steps of applying each orthogonal function of a single corresponding set of said known signal to said digital-to-analog converter to generate an excitation signal which varies according to the binary weighting induced by said orthogonal functions; and examining the output signal produced by each bit of said analog-to-digital converter under test by correlating said output response signal with each selected orthogonal function. The method yields a relatively complete statistical description of the performance characteristics.

In a preferred method for testing a digital-to-analog converter, the preferred excitation pattern is a set of mutually orthogonal bit pattern sequences based on the Walsh functions, the pattern being substantially uniformly distributed over the amplitude range. Each one of the Walsh functions is binary weighted, or weighted by the power of two, determined by the order of the function, since each Walsh function is applied to a selected bit input of the converter. A suitable substantially uniform amplitude distribution is achieved by ordering the orthogonal function set to synthesize a ramp function, i.e., a sampled staircase function.

Brief description of the drawings
Figure 1 is a first embodiment of the invention for testing or calibrating digital-to-analog converters.
Figure 2 is a second embodiment of the invention for calibrating or testing digital-to-analog converters.
Figure 3 is a third embodiment of the invention for calibrating analog-to-digital converters.

Detailed description of specific embodiments
According to the invention a converter under test is exercised with a specific signal pattern to produce a response from which basic performance parameters can be extracted simultaneously, such as total distortion, linearity, optimum gain, offset and the like. The testing technique is capable of generating, in real time, a satistically complete description of a device under test (DUT), either an analog-to-digital converter or a digital-to-analog converter.

Underlying the successful realization of the invention is the application of the theory of orthogonal functions, and more particularly, the application of a specific set of orthogonal functions, two state orthogonal functions, the Walsh functions or the sum of specific Walsh functions such as the modified Walsh functions, as a test signal for a device to be tested. The successful realization of simultaneous evaluation of several response parameters is based on the mutual orthogonality of simultaneously applied functions, each of which is distinctly weighted and simultaneously applied to form an excitation signal. Simultaneous evaluation of several response parameters is possible through fast transform techniques, especially Fast Walsh Transforms. Finally, the extraction of a reliable set of response parameters is based on the recognition that the excitation signal should be of a class of signals or bit patterns known as maximum entropy functions or signals. By maximum entropy, it is meant that all possible states or values of the excitation signal have an equal probability of occurrence in the time frame of interest. In other words, a maximum entropy signal has maximum uncertainty and substantially uniform amplitude probability distribution. A simple continuous linear ramp function or a sampled staircase function are examples of excitation signals in this class. Another example would be a time-scrambled discontinuous function assuming all the sampled values of a continuous ramp function during the same time period as a ramp function. Modified Walsh functions, which are a sum of Walsh functions and thus not mutually orthogonal, may also be used in circumstances where certain criteria are satisfied. A synthesized signal which is a suitable substitute for a Walsh function excitation for a digital sequence should satisfy the following conditions:

"Given a set of distinct non-zero order Walsh functions, each with distinct binary weights, if the modulo-two sum of their binary Walsh number is not zero and if the sequence numbers (i.e., number of state transitions) generate a logical true for all bits when "OR'd" bit by bit, then the sum of the binary weighted functions will be a maximum entropy sequency".

Because this sum is the sum of orthogonal functions, there can be simultaneous evaluation of a plurality of bits which are excited by modified Walsh functions.

A more complete discussion of the theory underlying the invention is found in Appendix A hereto, entitled "Application of Walsh Functions to Converter Testing". Appendix A is specifically made a part hereof.

Since the integrated product of orthogonal functions of differing order is by definition zero, and is non-zero if of the same order, orthogonal function excitation, by its nature, allows the response to any one function in a group of simultaneously applied functions in an excitation signal to be isolated for analysis. Hence, in testing a digital-to-analog converter, a single bit pattern comprising a plurality of orthogonal bit patterns may be applied to the inputs so that the precise contribution of each bit pattern to the total output can be statistically determined by multiplication and integration of orthogonal functions of the same order (i.e., correlation of orthogonal functions of the same order).

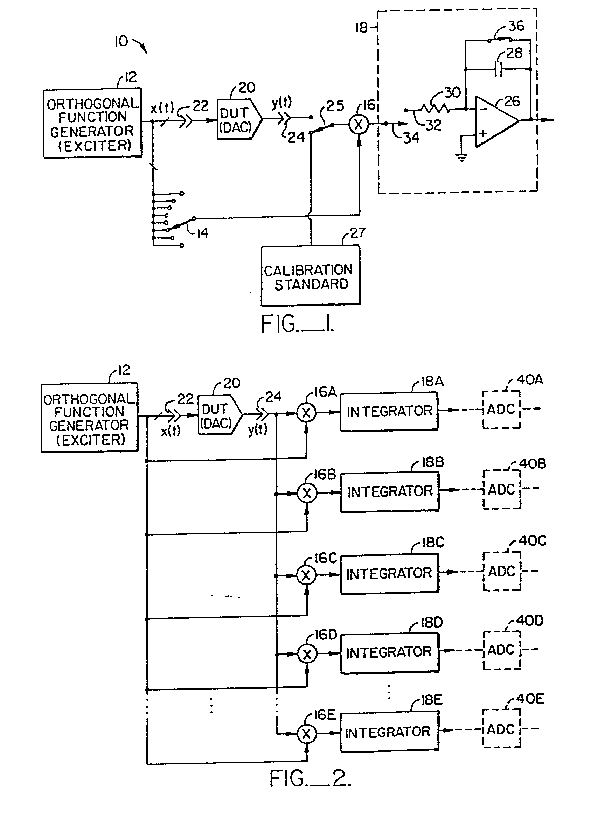

Turning to Figure 1, there is shown a block diagram of a basic embodiment of a digital-to-analog converter (DAC) test system 10 for testing a DAC or for calibrating a DAC for use in other tests. The DAC test system 10 comprises an orthogonal function generator or exciter 12, a selector switch 14, a multiplier 16, and an integrator 18. The device to be tested or device under test (DUT) 20 is a DAC coupled between a digital output terminal plug 22 and a single line analog input terminal 24. The exciter 12 has a digital output bus coupled to the output terminal plug 22 and to the selector switch 14. The selector switch 14 couples one bit line of the output bus to the input of multiplier 16. In the case of a two state or Walsh function generator, the multiplier 16 may be a simple two-state (positive/negative) multiplier of an analog signal applied through analog input terminal 24. A calibration switch 25 is preferably provided between the analog input terminal 24 and the multiplier 16 to allow connection of a calibration standard 27 to the input of the integrator 18. The calibration standard 27 may be a known fixed voltage within the intended amplitude range of the DUT 20. By applying a known fixed voltage to the input of the integrator 18 for a known time period and examining the response, the integrator 18 is calibrated.

The integrator 18 comprises an operational amplifier 26 having an integrating capacitor 28 between the inverting input and the output, a timing resistor 30 in the inverting input feed line 32, and two integration switches, namely, a normally open input switch 34 in the inverting feed line 32 and a normally closed integration switch 36 across the capacitor 28. As will be recognized by those skilled in the art, an integration of the input signal will be performed whenever switch 36 is opened while switch 34 is closed. The exciter 12, DUT 20, selector switch 14 and integration switches 34 and 36 are operated off of a common master clock to insure synchronous and accurate integration for the period of the converter test. It should also be recognized that the device under test 20 is capable of latching its level of output for a period corresponding to a conversion interval. Any set of orthogonal functions can be employed in the invention. However, two state orthogonal functions work particularly well in digital systems. The Walsh functions are a well-defined example of a set of suitable orthogonal functions. Hence, the specific examples which follow therefore refer to the Walsh functions for purposes of illustration and not limitation.

A typical test sequence according to the invention is as follows: The exciter 12 applies an orthogonal set of bit patterns as a single signal, namely, a set of Walsh function bit patterns each of which has an implicit binary weight of $2^m$, where each m corresponds to the order of the bit to which the Walsh function is connected by means of the bus connected to output terminal 22 to the DUT 20 and also to the selector switch 14. This excitation pattern is designated x(t). The DUT 20 produces an output response which is designated y(t). The Walsh functions or modified Walsh functions are as designated in Appendix A. The excitation pattern x(t) is characterized by the following summation:

**0 052 048**

$$x(t)= \sum_{m=0}^{M-1} 2^m \phi_{k,m}(t)$$

where $\phi_{k,m}(t)$ is the modified Walsh function generated by the exciter by Walsh functions of order k, m is the index, and M is the number of bits of the converter associated with the $m^{th}$ bit.

The output of the DUT 20 y(t) is characterized by the following summation:

$$y(t)= \sum_{n=0}^{2^M-1} a_n \ \psi_n(t)$$

where $a_n$ is the coefficient of the $n^{th}$ order Walsh function and $\psi_n(t)$ is the $n^{th}$ order Walsh function.

It should be noted from the Appendix that the modified Walsh function generated by the exciter is by definition:

$$\phi_m(t)=\tfrac{1}{2}(\psi_m(t)+\psi_o(t))$$

which assumes only values of +1 or 0. The modified Walsh functions are not an orthogonal set since they are offset to have a non-zero mean, as noted in the Appendix.

The selector switch 14 in Figure 1 is operative to isolate one digital line and to apply the orthogonal function signal on that digital line to the multiplier 16. The product of the multiplier 16 will be the response of the DUT 20 to the excitation of the selected digital bit line since the output is the product of orthogonal signals of the same order. The multiplier 16 output is then integrated by the integrator 18 through the network of the op-amp 26, resistor 30 and capacitor 28 whenever the switch 36 is open.

If the integrator 18 is cleared by momentarily closing switch 36, if the switch 34 is closed to apply the output response of the DUT 20 to the multiplier 16, and if the multiplier is switched by a Walsh function or modified Walsh function through the selector switch 14, then the integrator output at the end of the test period, T, will be as follows:

$$\frac{a_{k,m}}{2} = \frac{1}{T}\int_T y(t) \ \psi_{k,m}(t) \ dt$$

$$= \frac{1}{T} \sum_{n=o}^{2^M-1} a_n \int_T \phi_n(t) \ \psi_{k,m}(t) \ dt$$

if the order of the modified Walsh function is the same as the order of the Walsh function.

The above expression represents the value at the output of the integrator 18 at the end of the test sequence and represents an estimate of the dynamic weight of the $m^{th}$ bit of the digital-to-analog converter. In this manner each bit of the digital-to-analog converter under test can be characterized by a single value representing the dynamic weight of that bit. The set of actual values can thereafter be used to define a calibration transfer characteristic for linearity and offset in accordance with the criteria established in Appendix A. For example, the mean offset error for the digital-to-analog converter may be obtained by examining the zeroeth order modified Walsh function and applying that criteria to the above formula as follows:

$$a_o=\frac{1}{T}\int_T y(t)dt=\frac{1}{T} \sum_{n=0}^{2^M-1} a_n \int_T \psi_n(t) \ dt$$

where

$$\phi_k(t)=\phi_o(t).$$

Thus the zeroeth order coefficient of the Walsh function is the integrator output at the end of T seconds.

Figure 2 illustrates an alternative embodiment of the test system of Figure 1 in which all bits may be simultaneously examined. In the embodiment of Figure 2, the function switch 14 of Figure 1 has been omitted and a plurality of multipliers 16A, 16B, 16C, 16D and so forth through 16E have been introduced whereby each bit of the exciter can be examined simultaneously. Each multiplier 16a—e is coupled to receive the analog signal output of the DUT 20 and is also coupled to receive a digital signal of a selected one of the digital bit lines of the exciter 12. The output of each multiplier 16A—E is coupled to a corresponding integrator 18A, 18B, 18C, 18D and so forth through 18E. In this manner, the response of each bit of the DUT 20 can be uniquely defined as explained hereinabove with respect to a single bit. A DUT response so defined establishes a calibrated DAC which can be used for subsequent testing. It should also

5

be noted that the characterization of the device under test and any related processing may be performed digitally through suitable conversion to digital signals through for example analog-to-digital converters 40A, 40B, 40C, 40D and so forth through 40E.

The output in digitized form is readily adapted for digital analysis by either Fast Fourier Transform techniques or by Fast Walsh Transform techniques. As has been noted, the invention is uniquely suited to the use of Walsh functions as the set of orthogonal excitation functions. The technique of Fast Walsh Transform analysis is directly analogous to Fast Fourier Transform analysis. Computations of Fast Walsh Transforms have been taught elsewhere, see for example J. L. Shank's, "Computations of the Fast-Walsh Transforms", IEEE Transactions on Computers, pp. 457—459, May 1969. Those of ordinary skill in the art who have familiarized themselves with this invention will readily be able to implement Fast Walsh Transform analysis techniques in the same manner that Fast Fourier Transform techniques are implemented. Accordingly, the Shanks disclosure is incorporated herein by reference and made a part hereof. Nevertheless, there may well be test processing apparatus implementing Fast Walsh Transform techniques which are not immediately apparent from the present disclosure.

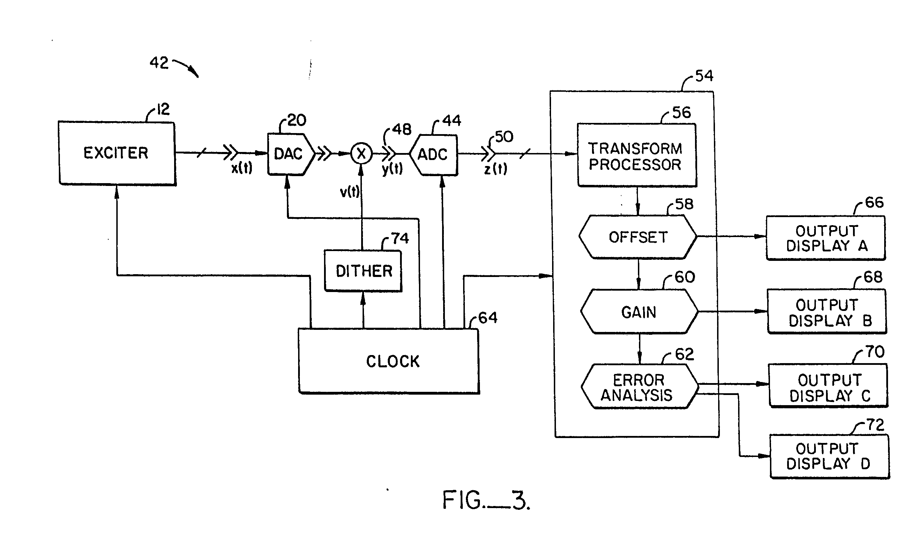

Figure 3 is a schematic diagram of a specific device for testing analog-to-digital converters. In Figure 3, an analog-to-digital converter (ADC) test system 42 for an unknown ADC 44 comprises a Walsh function generator or the equivalent exciter 12 coupled to a calibrated or reference DAC 20, the analog output of which is coupled to an exciter terminal 48 of an ADC 44 (the DUT). The output of the ADC 44 is coupled through a test response terminal 50 to a signal processor 54. The signal processor 54 may be a device which implements selected signal analysis functions. These signal analysis functions could be a Fast Walsh Transform through a Walsh transform processor 56, an offset computer 58, a gain computer 60, and an error analysis computer 62. All devices function through synchronism with a master clock 64. The output signals of the signal processor 54 are provided to suitable display devices as for example output display A 66, output display B 68, output display C 70 and output display D 72.

A dither generator may be provided to the input signal applied to the ADC 44 through a small dither generator 74. The dither signal v(t) insures that any signal presented to the ADC 44 will have an amplitude distribution that is dense relative to the resolution of the analog-to-digital converter under test. Hence, the dither signal has an amplitude of generally less than one least significant bit and a driving function selected from the set of orthogonal functions which is a function not used to excite the DAC 20. A key element in the invention is the calibrated reference DAC 20, the calibration having been accomplished by the technique discussed hereinabove. The basic source of excitation is the signal x(t) which is a binary weighted set of M Walsh functions as previously discussed. The output signal applied to the ADC 44, y(t), is the sum of the reference DAC output and the dither signal (v(t)), from the dither generator 74, just as the output signal can be considered to be a sum of Walsh functions with real coefficients. Thus v(t) may be expressed as:

$$v(t)= \sum_{n=0}^{2^M-1} \beta_n\psi_n(t)$$

and y(t) may be expressed as:

$$y(t)= \sum_{n=0}^{2^M-1} \alpha_n\psi_n(t)+v(t)$$

$$= \sum_{n=0}^{2^M-1} (\alpha_n+\beta_n)\psi_n(t)$$

The output z(t) of the ADC 44 excited by the function y(t) can also be characterized as a sum of Walsh functions where the coefficients account for the error introduced by the DAC as follows:

$$z(t)=a \sum_{n=0}^{2^M-1} \gamma_n\psi_n(t)$$

$$=y(t)+\varepsilon(t)$$

where
$\varepsilon(t)$ is the error introduced by the ADC;
$\gamma_n$ is the coefficient of the $n^{th}$ order Walsh function; and
a is the gain of the ADC.

The coefficients of the $n^{th}$ order Walsh functions for y(t) are known by previous calculation. The coefficients of the $n^{th}$ order Walsh functions of the function z(t) can be determined experimentally. Hence, solving for the error produces the following result:

6

$$\varepsilon(t) = z(t) - y(t)$$

$$= a \sum_{n=0}^{2^M-1} \gamma_n \psi_n(t) - y(t)$$

$$= a \sum_{n=0}^{2^M-1} \gamma_n \psi_n(t) - \sum_{n=0}^{2^M-1} (\alpha_n + \beta_n)\psi_n(t)$$

Continuing with the analysis, the mean squared error for the ADC may be determined as follows:

$$\overline{\varepsilon^2}(t) = \frac{1}{T} \int_T (\varepsilon(t))^2 dt$$

$$= \frac{a^2}{T} \int (\Sigma \gamma_n \psi_n(t))^2 dt$$

$$+ \frac{1}{T} \int_T y^2(t) dt$$

$$- \frac{2a}{T} \int_T y(t) \sum_{n=0}^{2^M-1} \gamma_n \psi_n(t) dt$$

The value of the optimum gain $a_{opt}$ that minimizes the mean square error may be obtained by setting to zero the first derivative with respect to the gain "a" and solving for "a" which by substitution becomes:

$$a_{opt} = \frac{\displaystyle\sum_{n=0}^{2^M-1} (\alpha_n + \beta_n)\gamma_n}{\displaystyle\sum_{n=0}^{2^M-1} \gamma_n^{\,2}}$$

The value for the optimum gain can therefore be computed by straightforward numerical computation techniques.

Linearity error can also be determined as follows: The binary weights of the modified Walsh functions due to the reference DAC outputs are first determined, the linearity error due to the reference DAC is determined and subtracted from each of the binary weights, and then the linearity function is compared with the excitation function, which is typically a maximum entropy function such as a ramp function wherein the contribution to observe linearity error due to the dither signal can be made negligible if synthesized from Walsh functions not used in the test pattern. The binary weights are defined as follows:

$$\lambda_{k,m} = \gamma_{k,m} - \beta_{k,m}$$

The ideal staircase or ramp function (i.e., uniformly quantized linear function) is expressed as follows:

$$r(t) = \sum_{m=0}^{M-1} 2^m \phi_{2m}(t)$$

Thus, the linearity error is expressed as follows:

$$\varepsilon_l = a_{opt} \sum_{m=0}^{M-1} \lambda_{k,m} \phi_{2m}(t) - \varepsilon'_l - r(t)$$

where $\varepsilon'_l$ is the linearity error due to the reference DAC. Which is by substitution:

$$\varepsilon_l = \sum_{m=0}^{M-1} (a_{opt}\lambda_{k,m} - 2^m)\phi_{2m}(t) - \varepsilon'_l$$

7

**0 052 048**

The technique for generating the offset error in a tester according to the invention for analog-to-digital converters involves subtracting the known input offsets from the expected mean output level. The offset error, which should ideally be adjusted to zero initially is thus computed from the expression:

$$\bar{\varepsilon}=a\gamma_o-\frac{a}{2}\sum_{m=0}^{M-1}(\alpha_{k,m}+\beta_{k,m})2^m$$

The dither function v(t) is not essential and therefore the coefficient $\beta$ can be omitted without loss of generality.

One method by which a DAC could be tested according to the invention is to substitute a DAC to be tested in place of the reference DAC 20 in the devices disclosed in the embodiment of Figure 3 where the ADC 44 has already been characterized by the methods outlined hereinabove. All computations are then referenced to the known responses of the ADC to an expected input signal. Deviations from the expected signal define the coefficients by which the DAC under test can be calibrated.

Appendix A
Application of Walsh functions to converter testing
E. A. Sloane, Fairchild, A. Schlumberger Company, Test Systems Group, San Jose, California 95110.

Abstract
A brief introduction to Walsh function leads into a discussion on the generation of maximum entropy sequences for the excitation of the device under test (DUT). A theoretical development relates the Walsh function expansions of the DUT response to converter offset, gain and linearity errors. A procedure for testing is also outlined.

Introduction to Walsh functions
Definitions
Walsh functions are a relatively new set of complete orthogonal basis functions that are capable of representing any reasonably well behaved function on a finite interval.

The essential properties of the Walsh functions may be summarized as follows:
1. They are "square" waves that assume value of $+/-1$.
2. The analysis interval is always subdivided into binary subintervals ($2^n$).
3. The expansion of a function on an analysis interval which is subdivided into $2^n$ sub-intervals may require up to $2^n$ unique Walsh functions.
4. Walsh functions are orthogonal.
5. Walsh functions are readily generated.

Figure 1 shows three sets of Walsh functions, $\{\psi_k\}$, of rank two, four or eight which are suitable for expanding functions with two, four or eight terms. The subscript associated with each $\psi$ represents the order of the function. Thus, the number of intervals determines the rank; the rank is equal to the total number of Walsh functions; and the order must be less than the rank.

Note that the Walsh functions of binary order, $\psi_{2k}$, are simple periodic "square" waves and are the basic kernels from which all other members of a given rank may be generated. The generating algorithm is

$$\psi_{k\oplus l}=\psi_k \cdot \psi_l$$

where $k\oplus l$ implies modulo-2 addition. For example:

$$\psi_3=\psi_1 \cdot \psi_2$$
$$\psi_5=\psi_1 \cdot \psi_4$$
$$\psi_4=\psi_1 \cdot \psi_5$$
$$\psi_0=\psi_k \cdot \psi_k$$

The Walsh functions are orthogonal because

$$\int_T\psi_k(t) \cdot \psi_l(t)dt=\begin{cases} T, & k=l \\ 0, & \text{otherwise} \end{cases}$$

where the limits of integration are over the analysis interval, T.

This means that if a function, x(t), can be expanded into Walsh functions then

$$x(t)=\sum_{k=0}^{2^n-1}\alpha_k\psi_k(t)$$

where the $\alpha_k$'s represent the Walsh coefficients analogous to Fourier series coefficients.

8

The Walsh coefficients can then be extracted from x(t) as follows:

$$a_m = \frac{1}{T}\int_T x(t)\psi_m(t)dt$$

$$\text{because} \quad a_m = \frac{1}{T}\sum_{k=0}^{2^N-1} a_k\int_T \psi_k(t) \cdot \psi_m(t)dt$$

and the orthogonality condition ensures that the integral is zero for all k except k=m.

The traditional Walsh function theory has been based on continuous functions of time. Even though we will be dealing with sampled time functions also, the basic theory is applicable but invokes sampled Walsh functions instead as shown in Figure 2, where + implies +1 and − implies −1.

In the sampled case, summations replace integrals so that

$$\sum_{n=0}^{2^k-1} \psi_l(n) \cdot \psi_m(n) = \begin{cases} 2^k, & l=m \\ 0, & \text{otherwise} \end{cases}$$

where $2^k$ is the rank, and

$$x(n) = \sum_{m=0}^{2^k-1} a_m\psi_m(n)$$

so that

$$a_m = 2^{-k}\sum_{n=0}^{2^k-1} x(n)\psi_m(n)$$

Both the discrete and continuous forms will be useful.

An additional method for cataloging Walsh functions is by their "sequency" order or by the number of zero crossings within the interval. For example, $\psi_0$ will have no zero crossings while $\psi_2$ has three. Each Walsh function will have a unique sequency number. The binary sequency numbers for rank-16 are shown in Figure 2.

Fast Walsh transforms

The similarity to Fourier Series also carries over to a fast Walsh transform (FWT) analogous to the well known fast Fourier transforms except that all multiplications are replaced by additions or subtractions.

Figure 3, graphically depicts, by means of signal flow diagrams, the FWT process for ranks 2, 4, and 8. The number of adds and subtracts is $k \cdot 2^k$ where $2^k$ is the rank.

The binary numbers at the top indicate the data sample number ranging from 0 to $2^k-1$. The lower numbers at the output of the transform process, give the order of Walsh coefficients. Note that these coefficients are in a "scrambled" reverse binary order, i.e., 100 and 001 are interchange, for example. If however, the data points are placed in reverse binary scrambled form, then the transformed coefficients will be in normal order.

Synthesis of test functions

The most important class of dynamic test functions is the "maximum entropy" set that has a uniform distribution of values on the interval spanned by the converter under test. For example, the uniform ramp 00...000, 00...001, 00...011, 00...100, 00...101, ..., 11...100, 11...101, 11...110, 11...111, would be a member of this set as well as all other functions that pass through each possible binary code only once for the duration of a rank. For a k-bit function, there are $2^k!$ members in this set.

If Walsh functions are used to represent the individual bit patterns it is possible to synthesize these patterns by following a simple set of rules. However, it will be convenient to define a modified Walsh function as

$$\phi_m(t) = \tfrac{1}{2}[\psi_0 + \psi_m]$$

which only assumes values of "+1" or "0". These modified Walsh functions have the following generating algorithm:

$$\phi_{k\oplus i} = \phi_k \boxplus \phi_i$$

where $\boxplus$ represents the "exclusive-or" operation.

Note, however, that the modified Walsh functions are not an orthogonal set, because of their non-zero mean.

The rule for generating a maximum entropy test signal with uniformly distributed values is based on the following conjecture:

"Given a set of m distinct non-zero order Walsh functions, each with distinct binary weights, the sum of the weighted functions will be a maximum entropy sequence if the mod-2 sum of their Walsh sequency number is not zero and/also if the sequency numbers when "or'd" bit-by-bit is true for all bits".

Thus, if it is desired to synthesize a maximum entropy, rank-16 function, we must choose 4 Walsh functions (corresponding to 4 bits) that satisfy the above conditions, for example, the set

$$\{\phi\}=\phi_1, \ \phi_2, \ \phi_4, \ \phi_8$$

| | Walsh order | Sequency order |
|---|---|---|
| $\phi_1$ | 0 0 0 1 | 0 0 0 1 |
| $\phi_2$ | 0 0 1 0 | 0 0 1 1 |
| $\phi_4$ | 0 1 0 0 | 0 1 1 1 |
| $\phi_8$ | 1 0 0 0 | 1 1 1 1 |
| Mod-2 Sum= | 1 1 1 1 | 1 1 1 1=Or'd bits |

Both conditions are satisfied, and not unexpectedly because these four functions may be used to form the basic ramp.

Consider the following:

$$f(n)=8\phi_1(n)+4\phi_2(n)+2\phi_4(n)+\phi_8(n)$$

The form or the function is evaluated in the following table:

| n= | 0 | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|---|
| $8\phi_1=$ | 8 | 8 | 8 | 8 | 8 | 8 | 8 | 8 | 0 | 0 | 0 | 0 | 0 | 0 | 0 | 0 |
| $4\phi_2=$ | 4 | 4 | 4 | 4 | 0 | 0 | 0 | 0 | 4 | 4 | 4 | 4 | 0 | 0 | 0 | 0 |
| $2\phi_4=$ | 2 | 2 | 0 | 0 | 2 | 2 | 0 | 0 | 2 | 2 | 0 | 0 | 2 | 2 | 0 | 0 |
| $\phi_8=$ | 1 | 0 | 1 | 0 | 1 | 0 | 1 | 0 | 1 | 0 | 1 | 0 | 1 | 0 | 1 | 0 |
| | 15, | 14, | 13, | 12, | 11, | 10, | 9, | 8, | 7, | 6, | 5, | 4, | 3, | 2, | 1, | 0 |

which is the linear descending ramp of rank-16.

If all of the 0's were complemented, then

$$f(n)=8\bar{\phi}_1+4\bar{\phi}_2+2\bar{\phi}_4+\bar{\phi}_8$$

and

| n= | 0 | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|---|
| $8\bar{\phi}_1=$ | 0 | 0 | 0 | 0 | 0 | 0 | 0 | 0 | 8 | 8 | 8 | 8 | 8 | 8 | 8 | 8 |
| $4\bar{\phi}_2=$ | 0 | 0 | 0 | 0 | 4 | 4 | 4 | 4 | 0 | 0 | 0 | 0 | 4 | 4 | 4 | 4 |
| $2\bar{\phi}_4=$ | 0 | 0 | 2 | 2 | 0 | 0 | 2 | 2 | 0 | 0 | 2 | 2 | 0 | 0 | 2 | 2 |
| $\bar{\phi}_8=$ | 0 | 1 | 0 | 1 | 0 | 1 | 0 | 1 | 0 | 1 | 0 | 1 | 0 | 1 | 0 | 1 |
| | 0, | 1, | 2, | 3, | 4, | 5, | 6, | 7, | 8, | 9, | 10, | 11, | 12, | 13, | 14, | 15, |

Note that complementing the Walsh functions reversed the order of the function. This is true because all of the $\phi$'s in this example have odd symmetry about the mid-point.

In general, time-reversal can be achieved by logically complementing only the $\phi$'s with odd symmetry about their mid-points.

For example, consider the following rank-8 functions (Figure 4a and 4b).

10

# 0 052 048

$$4\phi_4 = 4\ 0\ 4\ 0\ 4\ 0\ 4\ 0$$

$$2\phi_5 = 2\ 0\ 2\ 0\ 0\ 2\ 0\ 2$$

$$\phi_6 = 1\ 0\ 0\ 1\ 1\ 0\ 0\ 1$$

$$\overline{f(n) = 7\ 0\ 6\ 1\ 5\ 2\ 4\ 3}$$

and

$$4\overline{\phi}_4 = 0\ 4\ 0\ 4\ 0\ 4\ 0\ 4$$

$$2\phi_5 = 2\ 0\ 2\ 0\ 0\ 2\ 0\ 2$$

$$\phi_6 = 1\ 0\ 0\ 1\ 1\ 0\ 0\ 1$$

$$\overline{f(n) = 3\ 4\ 2\ 5\ 1\ 6\ 0\ 7}$$

If the entire function is complemented, the $2^m - 1$ complement is obtained (Figure 4c). If

$$f(n) = 4\overline{\phi}_4 + 2\overline{\phi}_5 + \overline{\phi}_6$$

$$4\overline{\phi}_4 = 0\ 4\ 0\ 4\ 0\ 4\ 0\ 4$$

$$2\overline{\phi}_5 = 0\ 2\ 0\ 2\ 2\ 0\ 2\ 0$$

$$\overline{\phi}_6 = 0\ 1\ 1\ 0\ 0\ 1\ 1\ 0$$

$$\overline{f(n) = 0, 7,\ 1, 6,\ 2, 5,\ 3, 4}$$

This rank-8 function could be further permuted by additional selective complementing as well as reassigning binary weights.

For a final example consider

$$f(n) = 4\overline{\phi}_6 + 2\overline{\phi}_5 + \phi_4$$

$$4\overline{\phi}_6 = 0\ 4\ 4\ 0\ 0\ 4\ 4\ 0$$

$$2\overline{\phi}_5 = 0\ 2\ 0\ 2\ 2\ 0\ 2\ 0$$

$$\phi_4 = 1\ 0\ 1\ 0\ 1\ 0\ 1\ 0$$

$$\overline{f(n) = 1, 6,\ 5, 2,\ 3, 4,\ 7, 0}$$

Note that this function, shown in Figure 4d, has assumed a "more random" appearance.

Theory of converter testing
Optimum gain and minimum M.S.E.

Let the input signal to a converter be synthesized from a set of M binary weighted modified Walsh functions of rank $2^M$, so that

$$x(t) = \sum_{m=0}^{M-1} 2^m \phi_{l,m}(t) \quad 1 \leqslant l \leqslant 2^M - 1$$

where l is the order of Walsh function and is assumed to be distinct for all l, and m corresponds to the bit number. The output signal from the converter, y(t), must be by a complete Walsh series so that gain and noise anomalies can be represented. Thus,

$$y(t) = a \sum_{n=0}^{2^M - 1} \alpha_n \psi_n(t)$$

where "a" is a system scale factor, n is the order of Walsh function, and $\alpha_n$ is the nth order coefficient.

Given the input and output of the converter, the mean-squared error, $\varepsilon^2$, can be found.

11

$$\overline{\varepsilon^2} = \frac{1}{T} \int (y(t) - x(t))^2 dt$$

Substituting the previous two expressions for x(t) and y(t) yields

$$\overline{\varepsilon^2} = \frac{a^2}{4} \sum_{n=0}^{2^M-1} a_n^2 + \frac{1}{4} \left[ \sum_{m=0}^{M-1} 2^{2m} + \left( \sum_{n=0}^{M-1} 2^m \right)^2 \right] - a \sum_{m=0}^{M-1} (a_{l,m} + a_0) 2^m$$

The value of gain, $a_{opt}$, that minimizes the M.S. error may be obtained by setting

$$\frac{d\overline{\varepsilon^2}}{da} = 0$$

and solving for a, which yields

$$a_{opt} = \frac{2 \sum_{m=0}^{M-1} (a_{l,m} + a_0) 2^m}{\sum_{n=0}^{2^M-1} a_n^2}$$

The minimum M.S. error, $\overline{\varepsilon_{min}^2}$, that results from adjusting the converter gain to $a_{opt}$ may be obtained by substituting this value in the expression for $\overline{\varepsilon^2}$.

$$\frac{\overline{\varepsilon_{min}^2}}{\overline{x^2(t)}} = 1 - \frac{4 \left( \sum_{m=0}^{M-1} (a_{l,m} + a_0) 2^m \right)^2}{\left[ \sum_{m=0}^{M-1} 2^{2m} + \left( \sum_{m=0}^{M-1} 2^m \right)^2 \right] \sum_{n=0}^{2^M-1} a_n^2}$$

where $\overline{x^2(t)}$ is the mean-squared value of the input, or

$$\overline{x^2(t)} = \frac{1}{T} \int_T x^2(t) dt = \frac{1}{4} \left\{ \sum_{m=0}^{M-1} 2^{2m} + \left( \sum_{m=0}^{M-1} 2^m \right)^2 \right\}$$

Linearity error

The linearity error of the converter, $\varepsilon_l$, may be obtained by taking the difference between the converter transfer characteristic and the ideal staircase ramp.

$$t_l = a_{opt} \sum_{m=0}^{M-1} a_{l,m} \phi_{2m}(t) - \sum_{m=0}^{M-1} 2^m \phi_{2m}(t)$$

or

$$t_l = \sum_{m=0}^{M-1} (a_{opt} a_{l,m} - 2^m) \phi_{2m}(t)$$

Note that the linearity error does not contain all of the Walsh terms that may contribute to the total M.S.E. but only includes those associated with the binary weights of the linear ramp.

Offset error

Finally, the converter offset may be obtained by measuring the mean error, $\bar{\varepsilon}$, in the converter output.

$$\bar{\varepsilon} = \frac{1}{T}\int_T (y(t)-x(t))dt$$

$$= \frac{1}{T}\int_T \left[ \sum_{n=0}^{2^M-1} a_n\psi_n(t) - \sum_{m=0}^{M-1} 2^m\phi_{l,m}(t) \right] dt$$

so that

$$\bar{\varepsilon} = \left[ a_0 - \frac{1}{2}\sum_{m=0}^{M-1} 2^m \right]$$

If this offset is removed prior to calculating the optimum gain, it will further reduce the M.S. error.

Conclusions

The outlined theory forms the basis for calibrating a DAC because the excitation signal is digital and hence is a near perfect drive signal. The response signal can be analyzed either by means of analog or digital processing techniques. Once characterized, the DAC can be used as a reference source for ADC testing using digital processing techniques.

The potential advantages of this technique include:

1. A simple dynamic calibration technique for the reference DAC.

2. A simple method for generating maximum entropy test signals that exercise each possible code.

3. Dynamic testing of converters allows for detecting "history" dependent or data dependent errors that are not now detected in test.

4. Test time is minimized because all weights are evaluated simultaneously.

The current state-of-the-art, based on static tests, or limited dynamic test techniques such as servo-controlled "dither" detection of transition voltages, leads to inadequate testing and long test times.

On the other hand, the dynamic Walsh function calibration technique of exciting individual bits of a DAC with orthogonal functions allows for the sorting of each weight's contribution, while dynamically exercising the device under test. Having calibrated the reference DAC, it is possible to generate a "calibrated" dynamic signal for testing either DAC's or ADC's that covers their full dynamic range.

References

"Advanced Analytical and Signal Processing Techniques: Application of Walsh Functions to Nonlinear Analysis", M. S. Corrington and R. N. Adams, Technical Report, ASTIA No. AD-277942, 1962.

"The Walsh Functions", N. J. Fine, Encyclopedic Dictionary of Physics, Pergamon Press, Oxford, 1969.

"The Generalized Walsh Functions", N. J. Fine, Transactions of Am. Math. Soc., vol. 69, pp. 66—77, 1950.

"On the Walsh Functions", N. J. Fine, Transactions of Am. Math. Soc., vol. 65, pp. 372—414, 1949.

"Testing Digital/Analog and Analog/Digital Converters", J. R. Naylor, IEEE Trans. Circuits and Systems, vol. CAS-25, No. 7, pp. 526—538, July 1978.

"Designing an Analog LSI Converter Test System", J. Seaton, B. Webster and P. Oiseau, Electronic Packaging and Production, January, 1980.

"Computation of the Fast Walsh-Fourier Transform", J. L. Shanks, IEEE Transactions on Computers, pp. 457—459, May, 1969. Also, IEEE Computer Group Repository, R-69-18.

"Analog-Digital Conversion Notes", D. H. Sheingold, Editor, Analog Devices, Inc., Norwood, Massachusetts, pp. 191—215, 1977.

"A Closed Set of Orthogonal Functions", J. L. Walsh, Am. Jour. of Math., vol. 45, pp. 5—24, 1923.

Figure 1. Typical Walsh Functions.

| Walsh order | | 0 | 1 | 2 | 3 | 4 | 5 | 6 | 7 | 8 | 9 | 10 | 11 | 12 | 13 | 14 | 15 →n | Sequency number |
|---|---|---|---|---|---|---|---|---|---|---|---|---|---|---|---|---|---|---|
| 0 0 0 0 | $\psi_0$ | + | + | + | + | + | + | + | + | + | + | + | + | + | + | + | + | 0 0 0 0 |
| 0 0 0 1 | $\psi_1$ | + | + | + | + | + | + | + | + | − | − | − | − | − | − | − | − | 0 0 0 1 |
| 0 0 1 0 | $\psi_2$ | + | + | + | + | − | − | − | − | + | + | + | + | − | − | − | − | 0 0 1 1 |
| 0 0 1 1 | $\psi_3$ | + | + | + | + | − | − | − | − | − | − | − | − | + | + | + | + | 0 0 1 0 |
| 0 1 0 0 | $\psi_4$ | + | + | − | − | + | + | − | − | + | + | − | − | + | + | − | − | 0 1 1 1 |
| 0 1 0 1 | $\psi_5$ | + | + | − | − | + | + | − | − | − | − | + | + | − | − | + | + | 0 1 1 0 |
| 0 1 1 0 | $\psi_6$ | + | + | − | − | − | − | + | + | + | + | − | − | − | − | + | + | 0 1 0 0 |
| 0 1 1 1 | $\psi_7$ | + | + | − | − | − | − | + | + | − | − | + | + | + | + | − | − | 0 1 0 1 |
| 1 0 0 0 | $\psi_8$ | + | − | + | − | + | − | + | − | + | − | + | − | + | − | + | − | 1 1 1 1 |
| 1 0 0 1 | $\psi_9$ | + | − | + | − | + | − | + | − | − | + | − | + | − | + | − | + | 1 1 1 0 |
| 1 0 1 0 | $\psi_{10}$ | + | − | + | − | − | + | − | + | + | − | + | − | − | + | − | + | 1 1 0 0 |
| 1 0 1 1 | $\psi_{11}$ | + | − | + | − | − | + | − | + | − | + | − | + | + | − | + | − | 1 1 0 1 |
| 1 1 0 0 | $\psi_{12}$ | + | − | − | + | + | − | − | + | + | − | − | + | + | − | − | + | 1 0 0 0 |
| 1 1 0 1 | $\psi_{13}$ | + | − | − | + | + | − | − | + | − | + | + | − | − | + | + | − | 1 0 0 1 |
| 1 1 1 0 | $\psi_{14}$ | + | − | − | + | − | + | + | − | + | − | − | + | − | + | + | − | 1 0 1 1 |
| 1 1 1 1 | $\psi_{15}$ | + | − | − | + | − | + | + | − | − | + | + | − | + | − | − | + | 1 0 1 0 |

Figure 2. Rank-16 sampled Walsh function

Figure 3. Fast Walsh Transform Flow Diagrams

Figure 4. Examples of Maximum Entropy Sequences

**Claims**

1. A method for dynamically testing an analog-to-digital converter comprising the steps of:

(a) generating an excitation signal for the analog-to-digital converter under test by applying a known signal to a digital-to-analog converter of a known transfer characteristic;

(b) applying said excitation signal to the analog-to-digital converter under test in order to generate a digital output response signal at the output of said analog-to-digital converter under test; and

(c) examining said digital output response signal in order to determine deviation of the output signal so produced from a computed standard;

characterized in that said known signal consists of a set of orthogonal digital functions over a defined interval and has its amplitude substantially uniformly distributed among allowable states to approximate a maximum entropy sequence signal; and further characterized by the steps of applying each orthogonal function of a single corresponding set of said known signal to said digital-to-analog converter to generate an excitation signal which varies according to the binary weighting induced by said orthogonal functions; and examining the output signal produced by each bit of said analog-to-digital converter under test by correlating said output response signal with each selected orthogonal function.

2. A method for dynamically testing an analog-to-digital converter according to Claim 1 wherein said step of examining said digital output response signal comprises the substeps of:

characterizing said excitation signal and said digital output response signal each as a sum of known time dependent orthogonal functions having constant amplitude coefficients;

identifying the amplitude coefficients of each of said functions; and

comparing the digital output response signal with said excitation signal to produce indices of deviation from an expected response.

3. The method according to Claim 1 further including the step of adding the output signal of said digital-to-analog converter to the output signal of a dither signal generator to produce an excitation signal having an amplitude distribution that is dense relative to the resolution of the digital-to-analog converter under test (DUT).

4. The method according to Claim 2 wherein said output response signal is characterized as:

$$z(t)=a \sum_{n=0}^{2^M-1} \gamma_n \psi_n(t)$$

$$=y(t)+\varepsilon(t)$$

where a is the gain of the analog to digital converter;

n is the index;

M is the order of the orthogonal function set;

y(t) is the excitation signal which is characterized as:

$$y(t)= \sum_{n=0}^{2^M-1} \alpha_n \psi_n(t);$$

$\alpha_n$ is the known $n^{th}$ coefficient of the $n^{th}$ order orthogonal function of the set;

$\gamma_n$ is the measured $n^{th}$ coefficient of the $n^{th}$ order orthogonal function of the set; and

$\varepsilon(t)$ is the error introduced by the analog to digital converter,

further comprising the steps of processing the measured and known coefficients according to the following function:

$$\varepsilon(t)=a \sum_{n=0}^{2^M-1} \gamma_n \psi_n(t)-y(t)$$

to determine the error $\varepsilon(t)$ introduced by the analog to digital converter.

5. The method according to claim 4 further comprising the steps of processing the known coefficients and the measured coefficients of the response according to the following function:

$$\overline{\varepsilon^2(t)}=\frac{1}{T}\int_T (a \sum_{n=0}^{2^M-1} \gamma_n \psi_n(t)-y(t))^2 dt$$

where T is the period to determine the mean squared error $\overline{\varepsilon^2(t)}$ of the analog to digital converter.

6. The method according to Claim 5 further comprising the steps of processing the known coefficients and the measured coefficients of the response according to the following function:

$$a_{opt} = \frac{\sum\limits_{n=0}^{2^M-1} (a_n + \beta_n)\gamma_n}{\sum\limits_{n=0}^{2^M-1} \gamma_n^2}$$

to determine the gain $a_{opt}$ that minimizes the mean square error.

7. The method according to Claim 6 further comprising the steps of processing the known coefficients and the measured coefficients of the response according to the following function:

$$\varepsilon_l = \sum_{m=0}^{M-1} (a_{opt}\gamma_{k,m} - 2^m)\phi_{2m}(t) - \varepsilon'_l$$

where $\gamma_{k,m}$ is the $k^{th}$ order binary weighted orthogonal function coefficient associated with the $m^{th}$ bit of the calibrated converter output;

$\varepsilon'_l$ is the known linearity error of the calibrated converter; and

$\phi_{2m}(t)$ is the $2^m$ th order modified orthogonal function or $\phi_m(t) = \frac{1}{2}[\psi_o(t) + \psi_{2m}(t)]$ to determine linearity error $\varepsilon_l$ of the converter under test.

8. The method according to Claim 7 further comprising the steps of processing said known coefficient and measured coefficients of the response according to the following functions:

$$\overline{\varepsilon} = a\gamma_o - \frac{a}{2}\sum_{m=0}^{M-1} a_{k,m}2^m\phi_n(t) - \overline{\varepsilon'}$$

where $\overline{\varepsilon'}$ is the known mean input offset linearity error of the calibrated converter; and

$\phi_n(t)$ is the $n^{th}$ order modified orthogonal function to determine the mean offset error of the converter under test.

9. The method according to Claims 2, 4, 5, 6, 7, or 8 wherein said orthogonal signal comprises a set of sampled two state orthogonal functions.

10. The method according to Claim 9 wherein said sampled two state orthogonal functions are Walsh functions.

11. The method according to Claim 10 wherein said step of examining said digital output response signal comprises the further substeps of:

processing said digital output response signals by means of a Fast Walsh Transform; and

comparing the digital output response signal with said excitation signal to determine at least the error introduced by said digital-to-analog converter, the mean square error, and the optimum gain of said analog-to-digital converter.

12. A method for dynamically testing a digital-to-analog converter comprising the steps of:

(a) generating a digital excitation signal;

(b) applying said digital excitation signal to a digital-to-analog converter to be tested to produce an output response signal; and

(c) applying said output response signal to an analog-to-digital converter having a known transfer characteristic in order to produce a digital processing signal at the output thereof;

characterized in that said digital excitation signal consists of a set of orthogonal functions having a known substantially uniform amplitude probability density function among allowable states for exciting substantially all allowable states of a digital-to-analog converter to which said generated digital excitation signal is applied; and

further characterized by the step of comparing measured coefficients and known coefficients characterizing said processing signal and said response to determine deviation of said output response signal from a computed signal produced by said processing signal.

13. A method according to Claims 1 to 11, characterized in that said digital-to-analog converter of known transfer characteristic is calibrated by the following steps:

generating a digital excitation signal consisting of a set of orthogonal functions, each orthogonal function being binary weighted such that the synthesis of said digital excitation signal is a substantially maximum entropy function;

applying said digital excitation signal to the input of the digital-to-analog converter to be calibrated in order to produce an output response signal;

multiplying the output response signal by an orthogonal function; and

integrating the multiplied output response signal through a calibrated analog signal integrator for the duration of the orthogonal function duration to produce an estimate of the dynamic weight of each selected bit of the digital-to-analog converter under test.

14. A method according to Claim 13, characterized in that the said analog signal integrator is calibrated by the steps of applying a known fixed analog standard signal to the input of said multiplier; multiplying said fixed analog standard by a signal consisting of a selected orthogonal function; and integrating the signal so multiplied over the duration of the orthogonal function signal to produce an output value characterizing said integrator relative to said calibration standard signal.

15. An apparatus for dynamically testing either a digital to analog converter or an analog to digital converter wherein the one or the other converter having a known transfer characteristic from which a response signal is defined, comprising:

a digital to analog converter coupled to receive a digital excitation signal;

an analog to digital converter coupled to receive the output signal from the digital-to-analog converter to generate a digital response signal; and

means for comparing the measured response with the known response to characterize the converter under test;

characterized by means for generating said digital excitation signal consisting of a set of orthogonal functions, the signal having a known substantially uniform amplitude probability density function among allowable states; and

further characterized in that said digital-to-analog converter is adapted to receive said digital excitation signal as a set of orthogonal functions, each function being applied at one bit input of said digital to analog converter to generate an analog response signal; and in that said means for comparing includes means for extracting from the output of said analog-to-digital converter coefficients of said orthogonal signal and for comparing those coefficients with the coefficients of the signal applied to the input of said digital-to-analog converter.

**Patentansprüche**

1. Ein Verfahren für dynamisches Prüfen eines Analog-Digital-Umsetzers, umfassend die Schritte:

(a) Erzeugen eines Erregungssignals für den zu prüfenden Analog-Digital-Umsetzer durch Anlegen eines bekannten Signals an einen Digital-Analog-Umsetzer einer bekannten Übertragungscharakteristik,

(b) Anlegen des genannten Erregungssignals an den zu prüfenden Analog-Digital-Umsetzer zwecks Erzeugung eines digitalen Ausgangs-Response-Signals am Ausgang des genannten zu prüfenden Analog-Digital-Umsetzers und

(c) Überprüfen des genannten digitalen Ausgangs-Response-Signals zwecks Bestimmung der Abweichung des Ausgangssignals, das so erzeugt worden ist, von einer berechneten Norm,

dadurch gekennzeichnet, daß das genannte bekannte Signal aus einem Satz orthogonaler digitaler Funktionen über ein definiertes Intervall besteht und seine Amplitude im wesentlichen gleichförmig verteilt über zulässige Zustände zwecks Annäherung an ein Sequenzsignal maximaler Entropie aufweist, und ferner gekennzeichnet durch die Schritte des Anlegens jeder orthogonalen Funktion eines einzelnen entsprechenden Satzes des genannten bekannten Signals an den genannten Digital-Analog-Umsetzer zum Erzeugen eines Erregungssignals, das sich entsprechend der binären Wichtung, eingeführt durch die genannten orthogonalen Funktionen, verändert, und Uberprüfen des Ausgangssignals, erzeugt durch jedes Bit des genannten zu prüfenden Analog-Digital-Umsetzers durch Korrelieren des genannten Ausgangs-Response-Signals mit jeder ausgewählten orthogonalen Funktion.

2. Ein Verfahren für das dynamische Prüfen eines Analog-Digital-Umsetzers nach Anspruch 1, bei dem der genannte Schritt der Überprüfung des genannten digitalen Ausgangs-Response-Signals die Unterschritte umfaßt:

Charakterisieren des genannten Erregungssignals und des genannten digitalen Ausgangs-Response-Signals jeweils als eine Summe von bekannten zeitabhängigen orthogonalen Funktionen mit konstanten Amplitudenkoeffizienten,

Identifizieren der Amplitudenkoeffizienten jeder der genannten Funktionen und

Vergleichen des digitalen Ausgangs-Response-Signals mit dem genannten Erregungssignal zum Erzeugen von Abweichungsindeces von einem erwarteten Response.

3. Das Verfahren nach Anspruch 1, ferner umfassend den Schritt des Addierens des Ausgangssignals des genannten Digital-Analog-Umsetzers zu dem Ausgangssignal eines Dither-Signalgenerators zum Erzeugen eines Erregungssignals mit einer Amplitudenverteilung, die dicht ist relativ zu der Auflösung des zu prüfenden Digital-Analog-Umsetzers.

4. Das Verfahren nach Anspruch 2, bei dem das Ausgangs-Response-Signal charakterisiert ist als:

$$z(t) = \sum_{n=0}^{2^M-1} \gamma_n \psi_n(t)$$

$$= y(t) + \varepsilon(t)$$

worin a die Verstärkung des Analog-Digital-Umsetzers ist, n der Index ist,

**0 052 048**

M die Ordnung des orthogonalen Funktionssatzes ist,
y(t) des Erregungssignal ist, das charakterisiert ist als

$$y(t)=\sum_{n=0}^{2^M-1} a_n\psi_n(t);$$

$a_n$ der bekannte n-te Koeffizient der orthogonalen Funktion n-ter Ordnung des Satzes ist,
$\gamma_n$ der gemessene n-te Koeffizient der orthogonalen Funktion n-ter Ordnung des Satzes ist und
c(t) der Fehler ist, eingeführt durch den Analog-Digital-Umsetzer, ferner umfassend die Schritte der Verarbeitung der gemessenen und bekannte Koeffizienten gemäß der folgenden Funktion:

$$\varepsilon(t)=a\sum_{n=0}^{2^M-1} \gamma_n\psi_n(t)-y(t)$$

zwecks bestimmung de Fehlers $\varepsilon(t)$, eingeführt durch den Analog-Digital-Umsetzer.

5. Das Verfahren nach Anspruch 4, ferner umfassend die Schritte der Verarbeitung der bekannten Koeffizienten und der gemessenen Koeffizienten des Response entsprechend der folgenden Funktion:

$$\overline{\varepsilon^2}(t)=\frac{1}{T}\int_T(a\sum_{n=0}^{2^M-1} \gamma_n\psi_n(t)-y(t))^2dt$$

worin T die Periode zur Bestimmung des quadratisch gemittelten Fehlers $\overline{\varepsilon^2}$ (t) des Analog-Digital-Umsetzers ist.

6. Das Verfahren nach Anspruch 5, ferner umfassend die Schritte der Verarbeitung der bekannten Koeffizienten und der gemessenen Koeffizienten des Response entsprechend der folgenden Funktion:

$$a_{opt}=\frac{\displaystyle\sum_{n=0}^{2^M-1} (a_n+\beta_n)\gamma_n}{\displaystyle\sum_{n=0}^{2^M-1} \gamma_n^2}$$

zur Bestimmung der Verstärkung $a_{opt}$, die den mittleren quadratischen Fehler minimiert.

7. Das Verfahren nach Anspruch 6, ferner umfassend die Schritte der Verarbeitung der bekannten Koeffizienten und der gemessenen Koeffizienten des Response entsprechend der folgenden Funktion:

$$\varepsilon_l=\sum_{m=0}^{M-1} (a_{opt}\gamma_{k,m}-2^m)\phi_{2m}(t)-\varepsilon'_l$$

worin $\gamma_{k,m}$ der binäre gewichtete Orthogonalfunktionskoeffizient k-ter Ordnung ist, assoziiert mit dem m-ten Bit des geeichten Umsetzerausgangs,
$\varepsilon'_l$ der bekannte Linearitätsfehler des kalibrierten Umsetzers ist, und
$\phi_{2m}(t)$ die modifizierte orthogonale Funktion $2^m$-ter Ordnung ist oder
$\phi_m(t)=\frac{1}{2}[\psi_o(t)+\psi_{2m}(t)]$ zur Bestimmung des Linearitätsfehlers $\varepsilon_l$ des zu prüfenden Umsetzers.

8. Das Verfahren nach Anspruch 7, ferner umfassend die Schritte der Verarbeitung des genannten bekannten Koeffizienten und der gemessenen Koeffizienten des Response entsprechend den folgenden Funktionen:

$$\overline{\varepsilon}-a\gamma_o-\frac{a}{2}\sum_{m=0}^{M-1} a_{k,m}2^m\phi_n(t)-\overline{\varepsilon'}$$

worin $\overline{\varepsilon'}$ der bekannte mittlere Eingangs-Offset-Linearitätsfehler des geeichten Umsetzers ist und
$\phi_n(t)$ die modifizierte orthogonale Funktion n-ter Ordnung ist zur Bestimmung des mittleren Offsetfehlers des zu prüfenden Umsetzers.

9. Das Verfahren nach Ansprüchen 2, 4, 5, 6, 7, oder 8, bei dem das genannte orthogonale Signal einen Satz von abgetasteten Zwei-Zustands-Orthogonalfunktionen umfaßt.

10. Das Verfahren nach Anspruch 9, bei dem die genannten abgetasteten Zwei-Zustands-Orthogonalfunktionen Walsh-Funktionen sind.

21

11. Das Verfahren nach Anspruch 10, bei dem der genannte Schritt der Überprüfung des genannten digitalen Ausgangs-Response-Signals die weiteren Unterschritte umfaßt:

Verarbeiten des genannten digitalen Ausgangs-Response-Signals mittels einer schnellen Walsh-Transformation und

Vergleichen des digitalen Ausgangs-Response-Signals mit dem genannten Erregungssignal zur Bestimmung zumindest des Fehlers, eingeführt durch den genannten Digital-Analog-Umsetzer, des mittleren quadratischen Fehlers, und der optimalen Verstärkung des genannten Analog-Digital-Umsetzers.

12. Ein Verfahren für dynamische Prüfung eines Digital-Analog-Umsetzers, umfassend die Schritte:

(a) Erzeugen eines digitalen Erregungssignals,

(b) Anlegen des genannten digitalen Erregungssignals an einen zu prüfenden Digital-Analog-Umsetzer zum Erzeugen eines Ausgangs-Response-Signals und

(c) Anlegen des genannten Ausgangs-Response-Signals an einen Analog-Digitalumsetzer mit einer bekannten Übertragungscharakteristik zwecks Erzeugung eines digitalen Verarbeitungssignals an dessen Ausgang,

dadurch gekennzeichnet, daß das genannte digitale Erregungssignal aus einem Satz von Orthogonalfunktionen besteht mit einer bekannten, im wesentlichen gleichförmigen Amplitudenwahrscheinlichkeitsdichtefunktion über zulässige Status' für die Erregung im wesentlichen aller zulässigen Status' eines Digital-Analog-Umsetzers an den das genannte erzeugte digitale Erregungssignal angelegt wird, und

ferner gekennzeichnet durch den Schritt des Vergleichens gemessener Koeffizienten und bekannter Koeffizienten, die das genannte Verarbeitungssignal charakterisieren und den genannten Response zur Bestimmung der Abweichung des genannten Ausgangs-Response-Signals von einem berechneten Signal, erzeugt durch das genannte Verareitungssignal.

13. Ein Verfahren nach Ansprüchen 1 bis 11, dadurch gekennzeichnet, daß der genannte Digital-Analog-Umsetzer bekannter Übertragungscharakteristik durch die folgenden Schritte geeicht wird:

Erzeugen eines digitalen Erregungssignals bestehend aus einem Satz von Orthogonalfunktionen, wobei jede Orthogonalfunktion binär derart gewichtet ist, daß die Synthese des genannten digitalen Erregungssignals eine Funktion im wesentlichen maximaler Entropie ist,

Anlegen des genannten digitalen Erregungssignal an den Eingang des zu eichenden Digital-Analog-Umsetzers zwecks Erzeugung eines Ausgangs-Response-Signals,

Multiplizieren des Ausgangs-Response-Signals mit einer Orthogonalfunktion und

Integrieren des multiplizierten Ausgangs-Response-Signals durch einen geeichten Analog-Signal-Integrator für die Dauer der Orthogonalfunktiondauer zum Erzeugen einer Abschätzung des dynamischen Gewichtes jedes ausgewählten Bits des zu prüfenden Digital-Analog-Umsetzers.

14. Ein Verfahren nach Anspruch 13, dadurch gekennzeichnet, daß der genannte Analog-Signal-Integrator geeicht wird durch die Schritte des Anlegens einer bekannten festen analogen Normsignals an den Eingang des genannten Multiplikators,

Multiplizieren des genannten festen analogen Normsignals mit einem Signal, bestehend aus einer ausgewählten Orthogonalfunktion, und

Integrieren des so multiplizierten Signals über die Dauer des Orthogonalfunktionssignals zum Erzeugen eines Ausgangswertes, der den genannten Integrator relativ zu dem genannten Eichnormsignal charakterisiert.

15. Eine Anordnung für die dynamische Prüfung entweder eines Digital-Analog-Umsetzers oder eines Analog-Digital-Umsetzers, bei dem der eine oder der andere Umsetzer eine bekannte Übertragungscharakteristik aufweist, woraus ein Response-Signal definiert ist, umfassend:

einen Digital-Analog-Umsetzer, angekoppelt zum Empfang eines digitalen Erregungssignals,

einen Analog-Digital-Umsetzer, angekoppelt zum Empfang des Ausgangssignals von dem Digital-Analog-Umsetzer zum Erzeugen eines digitalen Response-Signals, und

Mittel für den Vergleich des gemessenen Response mit dem bekannten Response zur Charakterisierung des zu prüfenden Umsetzers,

gekennzeichnet, durch Mittel für die Erzeugung eines genannten digitalen Erregungssignals, bestehend aus einem Satz von Orthogonalfunktionen, welches Signal eine bekannte im wesentlichen gleichförmige Amplitudenwahrscheinlichkeitsdichtefunktion über zulässige Status' aufweist, und

ferner dadurch gekennzeichnet, daß der genannte Digital-Analog-Umsetzer ausgebildet ist zum Empfang des genannten digitalen Erregungssignal als ein Satz von Orthogonalfunktionen, wobei jede Funktion an einen Biteingang des genannten Digital-Analog-Umsetzers angelegt wird zum Erzeugen eines analogen Response-Signals, und daß die genannten Mittel für den Vergleich Mittel umfassen für das Extrahieren aus dem Ausgang des genannten Analog-Digital-Umsetzers von Koeffizienten des genannten Orthogonal-Signals und für das Vergleichen jener Koeffizienten mit den Koeffizienten des Signals, angelegt an den Eingang des genannten Digital-Analog-Umsetzers.

**Revendications**

1. Procédé pour tester dynamiquement un convertisseur analogique-numérique comprenant les étapes suivantes:

(a) élaborer un signal d'excitation pour le convertisseur analogique-numérique en cours de test en appliquant un signal connu à un convertisseur numérique-analogique ayant une caractéristique de transfert connue;

(b) appliquer ledit signal d'excitation au convertisseur analogique-numérique en cours de test de façon à élaborer un signal de réponse numérique à la sortie du convertisseur analogique-numérique en cours de test; et

(c) examiner ledit signal de réponse de sortie numérique afin de déterminer l'écart du signal de sortie ainsi produit par rapport à un étalon calculé;

caractérisé en ce que ledit signal connu consiste en un ensemble de fonctions numériques orthogonales sur un intervalle défini et présente une amplitude distribuée sensiblement uniformément parmi les états possibles de façon à approximer un signal séquentiel d'entropie maximale; et caractérisé en outre par les étapes consistant à appliquer chaque fonction orthogonale d'un ensemble unique correspondant dudit signal connu audit convertisseur numérique-analogique pour engendrer un signal d'excitation qui varie selon le poids binare dû auxdites fonctions orthogonales; et à examiner le signal de sortie produit par chaque bit dudit convertisseur analogique-numérique en cours de test par corrélation dudit signal de réponse de sortie avec chaque fonction orthogonale sélectionnée.

2. Procédé pour tester dynamiquement un convertisseur analogique-numérique selon la revendication 1 dans lequel ladite étape d'examen dudit signal de réponse de sortie numérique comprend les sous-étapes suivantes:

caractériser chacun desdits signaux d'excitation et de réponse de sortie numérique comme une somme de fonctions orthogonales connues dépendant du temps et ayant des coefficients d'amplitude constants;

identifier les coefficients d'amplitude de chacune desdites fonctions; et

comparer le signal de réponse de sortie numérique audit signal d'excitation pour fournir des indices d'écart par rapport à une réponse prévue.

3. Procédé selon la revendication 1 comprenant de plus l'étape consistant à ajouter le signal de sortie dudit convertisseur numérique-analogue au signal de sortie d'un générateur de bruit pour produire un signal d'excitation ayant une distribution d'amplitude dense par rapport à la résolution du convertisseur numérique-analogique en cours de test.

4. Procédé selon la revendication 2 dans lequel ledit signal de réponse de sortie est caractérisé par l'expression:

$$z(t) = a \sum_{n=0}^{2^M-1} \gamma_n \psi_n(t)$$

$$= y(t) + \varepsilon(t)$$

dans laquelle a est le gain du convertisseur analogique-numérique

n est l'index

M est l'ordre de l'ensemble de fonctions orthogonales;

y(t) est le signal d'excitation caractérisé par l'expression:

$$y(t) = \sum_{n=0}^{2^M-1} \alpha_n \psi_n(t);$$

$\alpha_n$ est le $n^{\text{ième}}$ coefficient connu de la fonction orthogonale d'ordre n de l'ensemble;

$\gamma_n$ est le $n^{\text{ième}}$ coefficient mesuré de la fonction orthogonale d'ordre n de l'ensemble;

$\varepsilon(t)$ est l'erreur introduite par le convertisseur analogique-numérique,

comprenant en outre les étapes consistant à traiter les coefficients connus et mesurés selon la fonction suivante:

$$\varepsilon(t) = a \sum_{n=0}^{2^M-1} \gamma_n \psi_n(t) - y(t)$$

pour déterminer l'erreur $\varepsilon(t)$ introduire par le convertisseur analogique-numérique.

5. Procédé selon la revendication 4 comprenant de plus les étapes consistant à traiter les coefficients connus et les coefficients mesurés de la réponse selon la fonction suivante:

$$\overline{\varepsilon^2}(t) = \frac{1}{T} \int_T (a \sum_{n=0}^{2^M-1} \gamma_n \psi_n(t) - y(t))^2 dt$$

23

dans laquelle T est la période pour déterminer la moyenne des carrés des erreurs $\overline{\varepsilon^2}(t)$ du convertisseur analogique-numérique.

6. Procédé selon la revendication 5 comprenant de plus les étapes consistant à traiter les coefficients connus et les coefficients mesurés de la réponse selon la fonction suivante:

$$a_{opt}=\frac{\displaystyle\sum_{n=0}^{2^M-1}(\alpha_n+\beta_n)\gamma_n}{\displaystyle\sum_{n=0}^{2^M-1}\gamma_n^{\,2}}$$

pour déterminer le gain $a_{opt}$ qui minimise la moyenne des carrés des erreurs.

7. Procédé selon la revendication 6 comprenant de plus les étapes consistant à traiter les coefficients connus et les coefficients mesurés de la réponse selon la fonction suivante:

$$\varepsilon_l=\sum_{m=0}^{M-1}(a_{opt}\gamma_{k,m}-2^m)\phi_{2m}(t)-\varepsilon'_l$$

dans laquelle $\gamma_{k,m}$ est le coefficient d'ordre k de la fonction orthogonale binairement pondérée, associé au $n^{ième}$ bit de la sortie du convertisseur étalonné;

$\varepsilon'_l$ est l'erreur connue de linéarité du convertisseur étalonné; et

$\phi_{2m}(t)$ est la fonction orthogonale modifiée d'ordre $2^m$ ou $\phi_m(t)=\frac{1}{2}[\psi_o(t)+\psi_{2m}(t)]$ pour déterminer l'erreur de linéarité $\varepsilon_l$ du convertisseur en cours de test.

8. Procédé selon la revendication 7 comprenant de plus les étapes consistant à traiter lesdits coefficients connus et les coefficients mesurés de la réponse selon la fonction suivante:

$$\overline{\varepsilon}=a\gamma_o-\frac{a}{2}\sum_{m=0}^{M-1}\alpha_{k,m}2^m\phi_n(t)-\overline{\varepsilon'}$$

dans laquelle $\overline{\varepsilon'}$ est l'erreur de linéarité connue de décalage d'entrée moyen du convertissue étalonné; et

$\phi_n(t)$ est la fonction orthogonale modifiée d'ordre n pour déterminer l'erreur moyenne de décalage du convertisseur en cours de test.

9. Procédé selon les revendications 2, 4, 5, 6, 7 ou 8 dans lequel ledit signal orthogonal comprend un ensemble de fonctions orthogonales à deux états échantillonnées.

10. Procédé selon la revendication 9 dans lequel lesdites fonctions orthogonales à deux états échantillonnées sont des fonctions de Walsh.

11. Procédé selon la revendication 10 dans lequel ladite étape d'examen du signal de réponse de sortie numérique comprend en outre les sous-étapes suivantes:

traiter lesdits signaux de réponse de sortie numériques au moyen d'une transformée rapide de Walsh; et

comparer le signal de réponse de sortie numérique audit signal d'excitation pour déterminer au moins l'erreur introduite par le convertisseur numérique-analogique, la moyenne des carrés des erreurs, et le gain optimal dudit convertisseur analogique-numérique.

12. Procédé pour tester dynamiquement un convertisseur numérique-analogique comprenant les étapes suivantes:

(a) élaborer un signal d'excitation numérique;

(b) appliquer ledit signal d'excitation numérique à un convertisseur numérique-analogique à tester pour produire un signal de réponse de sortie; et

(c) appliquer ledit signal de réponse de sortie à un convertisseur analogique-numérique ayant une caractéristique de transfert connue de façon à produire un signal de traitement numérique à sa sortie; caractérisé en ce que le signal d'excitation numérique consiste en un ensemble de fonctions orthogonales ayant une densité de probabilité d'amplitude connue sensiblement uniforme parmi les états possibles pour exciter sensiblement tous les états possibles d'un convertisseur numérique-analogique auquel ledit signal d'excitation numérique est appliqué; et

caractérisé en outre par l'étape consistant à comparer les coefficients mesurés et les coefficients connus qui caractérisent ledit signal de traitement et ladite réponse pour déterminer l'écart dudit signal de réponse de sortie par rapport à un signal calculé fourni par ledit signal de traitement.

13. Procédé selon la revendications 1 à 11, caractérisé en ce que ledit convertisseur numérique-analogique de caractéristique de transfert connue est étalonné par les étapes suivantes:

élaborer un signal d'excitation numérique consistant en un ensemble de fonctions orthogonales,

24

chaque fonction orthogonale étant pondérée binairement de façon que la synthèse dudit signal d'excitation numérique soit sensiblement une fonction d'entropie maximale;

appliquer ledit signal d'excitation numérique à l'entrée du convertisseur numérique-analogique à étalonner de façon à produire un signal de réponse de sortie;

multiplier le signal de réponse de sortie par une fonction orthogonale; et

intégrer le signal de réponse de sortie multiplié au moyen d'un intégrateur étalonné de signal analogique pendant la durée de la fonction orthogonale pour fournir une estimation du poids dynamique de chaque bit sélectionné du convertisseur numérique-analogique en cours de test.

14. Procédé selon la revendication 13, caractérisé en ce que ledit intégrateur de signal analogique est étalonné par les étapes consistant à:

appliquer un signal étalon analogique fixe connu à l'entrée dudit multiplicateur;

multiplier ledit étalon analogique fixe par un signal consistant en une fonction orthogonale sélectionnée, et

intégrer le signal ainsi multiplié sur la durée du signal de fonction orthogonale pour produire une valeur de sortie caractérisant ledit intégrateur par rapport audit signal étalon.

15. Dispositif pour tester dynamiquement soit un convertisseur numérique-analogique, soit un convertisseur analogique-numérique dans lequel l'un ou l'autre des convertisseurs comporte une caractéristique de transfert connue à partir de laquelle est défini un signal de réponse, comprenant:

un convertisseur numérique-analogique adapté à recevoir un signal d'excitation numérique;

un convertisseur analogique-numérique adapté à recevoir le signal de sortie du convertisseur numérique-analogique pour engendrer un signal de réponse numérique; et

des moyens pour comparer la réponse mesurée et la réponse connue pour caractériser le convertisseur en cours de test;

caractérisé par des moyens pour élaborer ledit signal d'excitation numérique consistant en un ensemble de fonctions orthogonales, le signal ayant une densité de probabilité d'amplitude connue sensiblement uniforme parmi les états possibles; et

caractérisé de plus en ce que le convertisseur numérique-analogique est adapté à recevoir ledit signal d'excitation numérique sous la forme d'un ensemble de fonctions orthogonales, chaque fonction étant appliquée à une entrée à un bit dudit convertisseur numérique-analogique pour élaborer un signal de réponse analogique; et en ce que lesdits moyens de comparaison comprennent des moyens pour extraire, de la sortie dudit convertisseur analogique-numérique, les coefficients dudit signal orthogonal et pour comparer ces coefficients avec les coefficients du signal appliqué à l'entrée dudit convertisseur numérique-analogique.

0 052 048

FIG.—1.

FIG.—2.

FIG._3.